# FASCICULE DE BREVET EUROPEEN

(11) **EP 2 994 766 B1**
(45) Date de publication et mention de la délivrance du brevet: **04.01.2017**
(21) Numéro de dépôt: 14723349.8
(22) Date de dépôt: 24.04.2014
(51) Int. Cl.: G01R 31/11

(54) **PROCÉDÉ DE COMPENSATION DES INHOMOGÉNÉITÉS DE PROPAGATION POUR UN SIGNAL DE REFLECTOMÉTRIE TEMPORELLE**
VERFAHREN ZUR KOMPENSATION VON AUSBREITUNGSINHOMOGENITÄTEN FÜR EIN ZEITLICHES REFLEKTOMETRISCHES SIGNAL
METHOD FOR COMPENSATING FOR PROPAGATION INHOMOGENEITIES FOR A TEMPORAL REFLECTOMETRY SIGNAL

(30) Priorité: 07.05.2013 FR 1354159
(43) Date de publication de la demande: 16.03.2016
(73) Titulaire: Commissariat à l'Énergie Atomique et aux Énergies Alternatives, 75015 Paris (FR)
(72) Inventeur: AUZANNEAU, Fabrice, F-91300 Massy (FR); EL SAHMARANY, Lola, F-94230 Cachan (FR); INCARBONE, Luca, F-75015 Paris (FR)
(74) Mandataire: HAMMES, Pierre
(86) Numéro de dépôt international: PCT/EP2014/058312
(87) Numéro de publication internationale: WO 2014/180663

(56) Documents cités:
- EP-A2- 1 477 820
- WO-A1-2012/032125
- FR-A1- 2 987 450
- US-A- 4 538 103
- US-A- 5 083 086
- US-A1- 2004 073 395
- US-A1- 2007 030 010

## Description

La présente invention concerne le domaine des systèmes et procédés de diagnostic pour câble. Plus précisément l'invention concerne les méthodes de réflectométrie permettant de détecter et/ou localiser les défauts impactant un câble, en particulier les méthodes de réflectométrie temporelle.

L'invention a pour objet un procédé de compensation des inhomogénéités de propagation impactant un réflectogramme temporel mesuré pour un câble donné à partir de l'injection, dans ce câble, d'un signal de test, dit signal de réflectométrie, puis l'acquisition de ce signal réfléchi sur les singularités ou ruptures d'impédance, que comportent le câble.

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées, en toron de câble ou autre.

La réflectométrie dans le domaine temporel est une méthode habituellement utilisée dans le diagnostic de câbles et de réseaux filaires. Cette méthode consiste à injecter un signal dans un câble point-à-point ou un réseau de câbles puis à mesurer les échos renvoyés qui sont dus aux réflexions du signal injecté sur les singularités du câble. Le retard et l'amplitude de ces échos permettent d'obtenir des informations sur la structure ou sur les défauts électriques présents dans ce câble ou réseau de câbles et ainsi permettent de localiser, caractériser et éventuellement prédire une panne ou plus généralement un défaut électrique.

Les documents WO2012/032125, US2007/030010, US 4538103, US 2004/073395, US 5083086 et EP 1477820 décrivent différentes méthodes de réflectométrie connues.

Dans la mise en oeuvre d'un système de réflectométrie, il apparaît souvent que la mesure du signal réfléchi, appelée réflectogramme, est perturbée par diverses sources de bruit.

On distingue le bruit de mesure habituel d'origine externe, par exemple provenant de parasites dus à l'environnement du câble ou du réseau, et d'origine interne tel que des fluctuations spontanées du fait de la nature discrète des phénomènes à l'échelle microscopique, du bruit de fond, du bruit thermique et des perturbations impulsionnelles. Ce bruit est de nature aléatoire, il varie de manière stochastique dans le temps.

Un autre bruit, dit de propagation, peut aussi se superposer à la mesure utile du réflectogramme. Il est dû aux inhomogénéités du câble, réparties aléatoirement sur sa longueur, qui provoquent localement des petites réflexions du signal et créent des petits échos indésirables sur le réflectogramme.

D'une manière plus générale, on peut trouver sur le réflectogramme mesuré des échos indésirables dus à ces inhomogénéités ou à d'autres phénomènes tels que la réflexion du signal sur une jonction ou ramification, un connecteur, une charge en fin de câble ou tout autre dispositif lié au câble, par exemple un dispositif externe tel un jeu de barres, un chemin de câble ou une goulotte. Ces échos peuvent être confondus avec des pics caractéristiques de défauts que l'on cherche à identifier par le biais de la méthode de réflectométrie ou peuvent également masquer ces échos car leur amplitude est supérieure à celle des pics de défauts recherchés.

L'analyse du réflectogramme et l'identification des défauts recherchés peut donc être faussée par ces pics indésirables dus aux inhomogénéités de propagation.

L'invention consiste à concevoir un signal de test optimal, spécifiquement adapté aux inhomogénéités présentes sur un câble et qui va permettre de « nettoyer » le réflectogramme. Après l'injection de ce signal de test adapté selon l'invention, le réflectogramme obtenu ne contiendra plus aucun pic, sauf celui correspondant au point d'injection. L'apparition d'un défaut suite à l'injection de ce signal adapté se verra donc de manière très nette et sa localisation sera grandement facilitée.

Il est aussi possible de générer un signal adapté qui donne lieu à la mesure d'un réflectogramme non plus sans aucun pic mais avec des pics que l'on désire voir apparaître (si cela a un quelconque intérêt). Ces pics peuvent être des pics que l'on désire conserver, ou des pics permettant de positionner des repères pour aider à la localisation de défauts par la suite.

L'invention a pour objet un procédé de compensation des inhomogénéités de propagation dans un réflectogramme temporel mesuré pour un câble caractérisé en ce qu'il comprend les étapes suivantes, exécutées itérativement:
- Injecter un signal de test dans ledit câble,
- Mesurer la réflexion dudit signal de test pour former un réflectogramme temporel,
- Identifier au moins une portion temporelle dudit réflectogramme temporel comprenant au moins un pic en amplitude correspondant à une inhomogénéité de propagation,
- Soustraire du signal de test la portion temporelle identifiée du réflectogramme divisée par le coefficient de réflexion du signal au point d'injection et remplacer le signal de test par le résultat de la soustraction,

Selon un aspect particulier de l'invention, la portion temporelle dudit réflectogramme temporel identifiée comprend un seul pic en amplitude correspondant à la première inhomogénéité de propagation identifiée sur ledit réflectogramme temporel.

Selon un aspect particulier de l'invention, la portion temporelle dudit réflectogramme temporel identifiée est égale à l'intégralité dudit réflectogramme temporel.

Selon un aspect particulier de l'invention, le nombre d'itérations est configuré pour atténuer à une valeur seuil donnée, dans le signal de test, les pics en amplitude correspondants aux inhomogénéités de propagation.

Selon un aspect particulier de l'invention, le nombre d'itérations est configuré de sorte que les pics en amplitude correspondants aux inhomogénéités de propagation sont repoussés à une distance temporelle donnée, dans ledit réflectogramme temporel, du pic en amplitude correspondant au point d'injection.

Selon un aspect particulier de l'invention, le signal de test injecté à la première itération est un signal Gaussien.

L'invention a également pour objet un système de réflectométrie comprenant des moyens adaptés pour mettre en oeuvre le procédé de réflectométrie selon l'invention.

D'autres caractéristiques et avantages de la présente invention apparaîtront mieux à la lecture de la description qui suit en relation aux dessins annexés qui représentent :
- La figure 1, un organigramme des étapes de mise en oeuvre du procédé selon l'invention,
- Les figures 2a,2b,2c, trois diagrammes temporels représentant respectivement, un exemple de réflectogramme temporel présentant des inhomogénéités, le signal de test optimal obtenu par application du procédé selon l'invention et le réflectogramme temporel obtenu à partir de l'injection dudit signal de test optimal,
- La figure 3, un synoptique d'un système de réflectométrie comprenant des moyens adaptés pour mettre en oeuvre le procédé selon l'invention

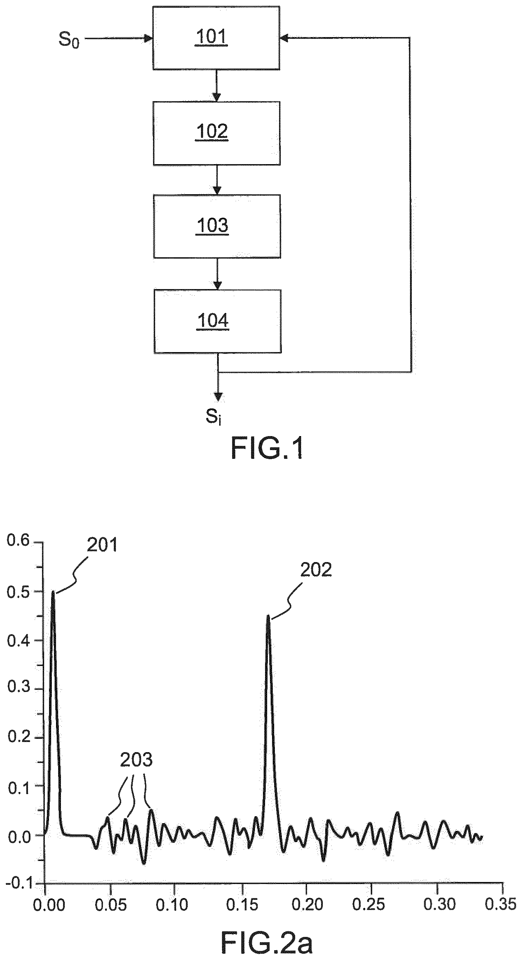

La figure 1 schématise, sur un organigramme, les étapes de mise en oeuvre du procédé selon l'invention.

Le principe à la base de l'invention consiste à annuler, sur le réflectogramme mesuré, l'un après l'autre les signaux réfléchis correspondants à des inhomogénéités de propagation. L'annulation de ces signaux se fait de façon itérative et aboutit à la formation d'un signal de test modifié adapté aux caractéristiques du câble à tester.

Dans une première étape 101, un signal de test S₀ est injecté dans un câble. Ce signal de test peut être un signal de type Gaussien, c'est-à-dire une impulsion de forme Gaussienne ou tout autre signal compatible d'une méthode de réflectométrie temporelle.

Dans une deuxième étape 102, on mesure la réflexion du signal de test afin de produire un premier réflectogramme temporel. Ce réflectogramme contient une pluralité de pics en amplitude, le premier de ces pics correspondant au point d'injection du signal de test dans le câble, le dernier de ces pics correspondant à un défaut franc, par exemple une fin de câble ou un court-circuit ou encore une charge électrique. Le réflectogramme contient également une pluralité de pics d'amplitude plus faible correspondant aux inhomogénéités de propagation.

Dans une troisième étape 103, on identifie une portion temporelle du réflectogramme mesuré comprenant au moins un pic en amplitude que l'on souhaite annuler ou compenser. Selon un premier mode de réalisation, cette portion temporelle peut correspondre au premier pic, selon l'axe temporel du réflectogramme, que l'on souhaite compenser. Selon un second mode de réalisation, cette portion temporelle peut également comprendre plusieurs pics à compenser ou être égale à l'intégralité du réflectogramme mesuré.

Dans une quatrième étape 104, la portion temporelle identifiée à l'étape 103 est pondérée par une estimée du coefficient de réflexion du signal au point d'injection dans le câble puis est soustraite au signal de test afin de former un signal de test modifié S₁. La pondération appliquée consiste en une division par une estimée du coefficient de réflexion.

Les étapes 101 à 104 sont ensuite itérées plusieurs fois afin de modifier successivement le signal de test jusqu'à obtenir un signal de test modifié final Si qui est adapté aux caractéristiques du câble.

Une fois ce signal de test modifié final Si construit, il peut être utilisé par toute méthode de réflectométrie temporelle connue afin de détecter, localiser ou de façon générale caractériser des défauts francs ou non francs impactant le câble dans le futur.

Grâce à la compensation des phénomènes liés aux inhomogénéités de propagation, le réflectogramme mesuré en utilisant le signal de test modifié selon l'invention est nettoyé des pics parasites et ne contiendra plus que des pics d'amplitude correspondant à des défauts que l'on souhaite identifier.

Le nombre d'itérations opérées est un paramètre du procédé. Il est configuré de sorte à atténuer l'amplitude des pics que l'on souhaite compenser en dessous d'une valeur seuil donnée. Il peut également être configuré de sorte à repousser les pics que l'on souhaite compenser à une certaine distance du pic correspondant au point d'injection, par exemple au delà du pic correspondant à la terminaison du câble ou de la portion de câble que l'on souhaite tester.

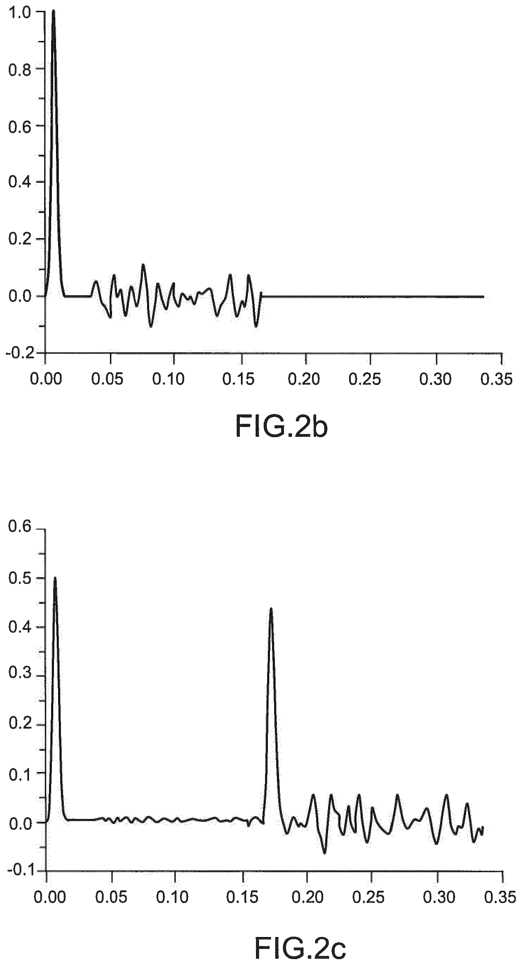

Les figures 2a,2b,2c illustrent sur trois diagrammes temporels, le fonctionnement du procédé selon l'invention.

La figure 2a représente le réflectogramme temporel obtenu à l'étape 102 de la 1^{ère} itération du procédé, autrement dit le réflectogramme initial. Ce réflectogramme comporte un premier pic 201 correspondant au point d'injection du signal de test, qui est ici un signal Gaussien, un deuxième pic 202 correspondant à la terminaison du câble sur laquelle le signal se réfléchit et une pluralité de pics secondaires 203 correspondant aux inhomogénéités de propagation.

La figure 2b représente le signal de test modifié Si à l'issu de l'exécution du procédé selon l'invention.

La figure 2c représente le réflectogramme temporel obtenu en injectant dans le câble le signal de test modifié Si représenté à la figure 2b.

On voit que les pics secondaires 203 sont fortement atténués entre le point d'injection 201 et la terminaison du câble 202.

Le procédé selon l'invention peut s'appliquer plus généralement pour compenser tout pic d'amplitude non désiré dans un réflectogramme temporel. Par exemple, dans le cas d'une ligne électrique formée par deux tronçons reliés entre eux par une interface, un pic de désadaptation entre les deux tronçons existe sur le réflectogramme initial. Ce pic peut être compensé de la même façon que les pics liés aux inhomogénéités de propagation en exécutant le procédé selon l'invention.

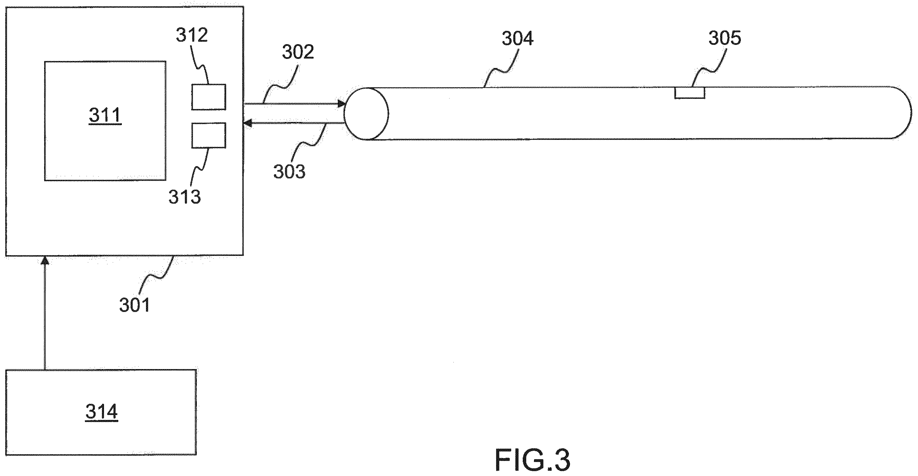

La figure 3 décrit un synoptique d'un exemple de système de réflectométrie selon l'invention.

Un câble à tester 304 présente un défaut 305 à une distance quelconque d'une extrémité du câble.

Le système de réflectométrie 301 selon l'invention comprend un composant électronique 311 de type circuit intégré, tel un circuit à logique programmable, par exemple de type FPGA, ou micro-contrôleur, adapté à exécuter deux fonctions. D'une part, le composant 311 permet de générer un signal de réflectométrie s(t) à injecter dans le câble 304 sous test. Le signal de réflectométrie s(t) est déterminé selon la méthode itérative décrite à la figure 1. Ce signal généré numériquement est ensuite converti via un convertisseur numérique-analogique 312 puis injecté 302 à une extrémité 306 du câble. Le signal s(t) se propage dans le câble et est réfléchi sur la singularité engendrée par le défaut 305. Le signal réfléchi est rétropropagé jusqu'au point d'injection 306 puis capturé 303, converti numériquement via un convertisseur analogique-numérique 313, et transmis au composant 311. Le composant électronique 311 est en outre adapté à exécuter les étapes du procédé selon l'invention décrit ci-dessus afin de produire, à partir du signal s(t) reçu, un réflectogramme temporel qui peut être transmis à une unité de traitement 314, de type ordinateur, assistant numérique personnel ou autre pour afficher les résultats des mesures sur une interface homme-machine. Le réflectogramme temporel mesuré est également utilisé pour modifier le signal de test s(t) de sorte à obtenir un signal optimal qui permet de supprimer les inhomogénéités de propagation dans le réflectogramme temporel mesuré au cours d'une itération ultérieure.

Le système 301 décrit à la figure 1 est un exemple de réalisation nullement limitatif. En particulier les deux fonctions exécutées par le composant 311 peuvent être séparées dans deux composants ou dispositifs distincts. Le système peut également fonctionner avec des signaux analogiques, dans ce cas les convertisseurs analogique-numérique et numérique-analogique ne sont pas nécessaires. Au lieu d'injecter et/ou de mesurer le signal réfléchi à une extrémité du câble sous test, il est également possible de réaliser l'injection ou la mesure du signal réfléchi en un point quelconque du câble.

Le système de réflectométrie selon l'invention peut également être constitué d'un équipement portatif, du type tablette tactile ou téléphone intelligent couplé à des moyens de connexion à un câble.

Le procédé selon l'invention peut être implémenté, dans le composant électronique 311 à partir d'éléments matériel et/ou logiciel. Il peut notamment être mis en oeuvre en tant que programme d'ordinateur comportant des instructions pour son exécution. Le programme d'ordinateur peut être enregistré sur un support d'enregistrement lisible par un processeur.

## Revendications

1. Procédé de compensation des inhomogénéités de propagation dans un réflectogramme temporel mesuré pour un câble donné, comprenant les étapes suivantes:
- Injecter (101) un signal de test dans ledit câble,
- Mesurer (102) la réflexion dudit signal de test pour former un réflectogramme temporel,
- Identifier (103) au moins une portion temporelle dudit réflectogramme temporel comprenant au moins un pic en amplitude correspondant à une inhomogénéité de propagation,
ledit procédé étant **caractérisé en ce que** :
- Il comprend en outre l'étape de soustraire (104) du signal de test la portion temporelle identifiée du dit réflectogramme, divisée par le coefficient de réflexion du signal au point d'injection et remplacer le signal de test par le résultat de la soustraction (104),
- lesdites étapes du procédé sont exécutées itérativement.

2. Procédé de compensation des inhomogénéités de propagation selon la revendication 1 dans lequel la portion temporelle dudit réflectogramme temporel identifiée comprend un seul pic en amplitude correspondant à la première inhomogénéité de propagation identifiée sur ledit réflectogramme temporel.

3. Procédé de compensation des inhomogénéités de propagation selon la revendication 1 dans lequel la portion temporelle dudit réflectogramme temporel identifiée est égale à l'intégralité dudit réflectogramme temporel.

4. Procédé de compensation des inhomogénéités de propagation selon l'une des revendications précédentes dans lequel le nombre d'itérations est configuré pour atténuer à une valeur seuil donnée, dans le signal de test, les pics en amplitude correspondants aux inhomogénéités de propagation.

5. Procédé de compensation des inhomogénéités de propagation selon l'une des revendications précédentes dans lequel le nombre d'itérations est configuré de sorte que les pics en amplitude correspondants aux inhomogénéités de propagation sont repoussés à une distance temporelle donnée, dans ledit réflectogramme temporel, du pic en amplitude correspondant au point d'injection.

6. Procédé de compensation des inhomogénéités de propagation selon l'une des revendications précédentes dans lequel le signal de test injecté à la première itération est un signal Gaussien.

7. Système de réflectométrie comprenant des moyens adaptés pour mettre en oeuvre le procédé de réflectométrie selon l'une des revendications précédentes.

## Patentansprüche

1. Verfahren zur Kompensation der Ausbreitungsinhomogenitäten in einem für ein gegebenes Kabel gemessenen zeitlichen Reflektogramm, umfassend die folgenden Schritte:
- Injizieren (101) eines Testsignals in das Kabel,
- Messen (102) der Reflexion des Testsignals, um ein zeitliches Reflektogramm zu bilden,
- Identifizieren (103) zumindest eines zeitlichen Abschnitts des zeitlichen Reflektogramms, der zumindest eine Amplitudenspitze umfasst, die einer Ausbreitung sinhomo genität entspricht,
wobei das Verfahren **dadurch gekennzeichnet ist, dass**:
- es weiterhin den Schritt des Subtrahierens (104), vom Testsignal, des identifizierten zeitlichen Abschnitts des Reflektogramms, dividiert durch den Reflexionskoeffizienten des Signals am Injektionspunkt, und Ersetzen des Testsignals durch das Ergebnis der Subtraktion (104) umfasst,
- die Schritte des Verfahrens iterativ ausgeführt werden.

2. Verfahren zur Kompensation der Ausbreitungsinhomogenitäten nach Anspruch 1, wobei der identifizierte zeitliche Abschnitt des zeitlichen Reflektogramms eine einzige Amplitudenspitze umfasst, die der ersten Ausbreitungsinhomogenität, identifiziert auf dem zeitlichen Reflektogramm, entspricht.

3. Verfahren zur Kompensation der Ausbreitungsinhomogenitäten nach Anspruch 1, wobei der identifizierte zeitliche Abschnitt des zeitlichen Reflektogramms gleich der Gesamtheit des zeitlichen Reflektogramms ist.

4. Verfahren zur Kompensation der Ausbreitungsinhomogenitäten nach einem der vorstehenden Ansprüche, wobei die Anzahl von Iterationen dazu konfiguriert ist, bei einem gegebenen Schwellenwert, im Testsignal, die den Ausbreitungsinhomogenitäten entsprechenden Amplitudenspitzen abzuschwächen.

5. Verfahren zur Kompensation der Ausbreitungsinhomogenitäten nach einem der vorstehenden Ansprüche, wobei die Anzahl von Iterationen so konfiguriert ist, dass die den Ausbreitungsinhomogenitäten entsprechenden Amplitudenspitzen zu einer gegebenen zeitlichen Distanz, im zeitlichen Reflektogramm, von der dem Injektionspunkt entsprechenden Amplitudenspitze zurückgeschoben werden.

6. Verfahren zur Kompensation der Ausbreitungsinhomogenitäten nach einem der vorstehenden Ansprüche, wobei das bei der ersten Iteration injizierte Testsignal ein gaußsches Signal ist.

7. Reflektometriesystem, umfassend Mittel, die zum Ausführen des Reflektometrieverfahrens nach einem der vorstehenden Ansprüche angepasst sind.

## Claims

1. A method for compensating for the propagation inhomogeneities in a time-domain reflectogram measured for a given cable, comprising the following steps:
- injecting (101) a test signal into said cable,
- measuring (102) the reflection of said test signal to form a time-domain reflectogram,
- identifying (103) at least a time portion of said time-domain reflectogram comprising at least one amplitude peak corresponding to a propagation inhomogeneity, said method being **characterised in that**:
- it further comprises the step of subtracting (104) the identified time portion of said reflectogram, divided by the signal reflection coefficient at the injection point, from the test signal, and replacing the test signal with the result of the subtraction (104),
- said method steps being carried out iteratively.

2. The method for compensating for the propagation inhomogeneities according to claim 1, wherein the identified time portion of said time-domain reflectogram comprises a single amplitude peak, corresponding to the first propagation inhomogeneity identified in said time-domain reflectogram.

3. The method for compensating for the propagation inhomogeneities according to claim 1, wherein the identified time portion of said time-domain reflectogram is equal to the whole of said time-domain reflectogram.

4. The method for compensating for the propagation inhomogeneities according to any of the preceding claims, wherein the number of iterations is configured to attenuate the amplitude peaks corresponding to the propagation inhomogeneities at a given threshold in the test signal.

5. The method for compensating for the propagation inhomogeneities according to any of the preceding claims, wherein the number of iterations is configured in such a way that the amplitude peaks corresponding to the propagation inhomogeneities are pushed back to a given time-domain distance, in said time-domain reflectogram, from the amplitude peak corresponding to the injection point.

6. The method for compensating for the propagation inhomogeneities according to any of the preceding claims, wherein the test signal injected in the first iteration is a Gaussian signal.

7. A reflectometry system comprising means suitable for executing the reflectometry method according to any of the preceding claims.
